# EUROPÄISCHE PATENTANMELDUNG

(11) **EP 1 727 411 A2**
(43) Veröffentlichungstag der Anmeldung: **29.11.2006**
(21) Anmeldenummer: 06405195.6
(22) Anmeldetag: 10.05.2006
(51) Int. Cl.: H05K 7/20

(54) **Kühlvorrichtung für Serverschrank**

(30) Priorität: 23.05.2005 CH 8822005
(71) Anmelder: Brüco Swiss AG, 8153 Rümlang (CH)
(72) Erfinder: Strebel, Marcel, 8934 Knonau (CH); Kielholz, Leopold, 8055 Zürich (CH)
(74) Vertreter: Schneider Feldmann AG Patent- und Markenanwälte

(57) **Zusammenfassung**

Es wird eine Kühlvorrichtung (1) für einen Serverschrank (2) vorgeschlagen, die gerade für Einbauten mit hoher Wärmeerzeugung bei großer Packungsdichte, zum Beispiel bei Blade-Servern, eine stark erhöhte Kühlleistung ermöglicht, ohne den Aufbau des Serverschrankes und dessen Aufstellung zu erschweren und dabei ohne den Einsatz von Wasser oder einer anderen Kühlflüssigkeit auskommt. Zudem wird ein Serverschrank mit einer solchen Kühlvorrichtung und ein Verfahren zum Betrieb einer solchen Kühlvorrichtung vorgeschlagen. Die Kühlvorrichtung (1) erlaubt es jeder wärmeerzeugenden Einheit über Windschächte (11-16) individuell gesteuert eine ausreichende Kühlluftmenge zuzuführen. Ein überhitzen der oberen Einheiten, wie es bei den bisher bekannten luftgekühlten Systemen mit ungerichteter Luftzufuhr vorkommen konnte, wird durch die neue Kühlvorrichtung und das Verfahren zu deren Betrieb ausgeschlossen.

## Beschreibung

Die vorliegende Erfindung betrifft eine Kühlvorrichtung zur Kühlung eines Serverschranks mit einer Mehrzahl von wärmeerzeugenden Einbauten, die im Innenraum des Schrankes vertikal übereinander angeordnet sind. Den wärmeerzeugenden Einbauten wird über Zuführschächte individuell Kühlluft zugeführt, wobei die Zuführschächte vorzugsweise in einer Luftschachteinheit zusammengefasst sind. Die Erfindung betrifft zudem einen Serverschrank mit einer solchen Kühlvorrichtung und ein Verfahren zum Betrieb der Kühlvorrichtung.

Steckbare, vernetzte Rechner, auch "Blade-Server" genannt, spielen seit ihrer Einführung im Jahre 2002 eine immer wichtigere Rolle in der Gestaltung von Rechenzentren. Ihr Hauptvorteil liegt darin, dass sie auf kleinstem Raum enorm viel Rechenleistung bieten. Fast alle großen Hersteller bieten inzwischen die etwa 10 x 35 cm großen Blades an, auf denen Prozessor, Arbeitsspeicher und Anschlüsse, also alle wichtigen Komponenten eines Server-Rechners, vorhanden sind. Die Blades werden vertikal eingebaut und lassen sich im "hot swop" Verfahren im laufenden Betrieb des Systems austauschen. In die weit verbreiteten 19 Zoll Racks passen bis zu 64 dieser Blades. Ausgerüstet mit Prozessoren der neuesten Generation vereinigen diese Server nicht nur eine immense Rechenleistung auf kleinstem Raum, sondern sie erzeugen auch massiv Abwärme, die von den Server-seitig vorgesehenen Kühlmitteln und

Ventilatoren nicht mehr ausreichend abgeführt werden kann.

Für Schaltschränke mit kompakten Einbauten mit hoher Wärmeerzeugung in grosser Packungsdichte wurde bereits in der DE-A1-10326803 vorgeschlagen einen Luft-/Wasser-Wärmetauscher im Bodenbereich des Schaltschrankes anzuordnen, der mit seiner Luft-Eingangsseite mit externer Kaltluft versorgt wird und

Teil eines geschlossenen Kühlmittelkreislaufes ist. Im Kühlmittelkreislauf wird Wasser vom Wärmetauscher den Kühlkörpern, die jeweils den einzelnen wärmeerzeugenden Einbauten zugeordnet sind, zugeführt. Dabei sind die übereinander angeordneten Einbauten mit ihren Kühlkörpern über Gerätezuleitungen mit einer Vorlaufleitung und einer Rücklaufleitung verbunden und die Anschlüsse bestehen vorzugsweise aus lösbaren Kupplungen. Die Kühlvorrichtung der DE-A1-10326803 bringt zwar eine Kühlleistung, die auch für Bladeserver ausreichend ist, aber die Gefahr von Funktionsstörungen und Schäden durch austretendes Wasser ist erheblich. Es ist daher ein absolutes Muss, die Dichtigkeit aller Komponenten des Kühlmittelkreislaufes sicherzustellen, was wiederum die Kosten für ein solches System erhöht. Beim Wechseln einzelner Kühlkörper oder anderer Baugruppen des Kühlmittelkreislaufes lässt es sich kaum vermeiden, dass Wasser austritt. Bei den Server-Herstellern und erst recht bei den Betreibern besteht daher nach wie vor eine grundsätzliche Abneigung mit Wasser zu Kühlen.

Es ist daher die Aufgabe der vorliegenden Erfindung eine Kühlvorrichtung der Eingangs genannten Art zur Verfügung zu stellen, die gerade für Einbauten mit hoher Wärmeerzeugung bei großer Packungsdichte eine stark erhöhte Kühlleistung ermöglicht, ohne den Aufbau des Serverschrankes und dessen Aufstellung zu erschweren und dabei ohne den Einsatz von Wasser oder einer anderen Kühlflüssigkeit auskommt. Zudem sollen ein Serverschrank mit einer solchen Kühlvorrichtung und ein Verfahren zum Betrieb einer solchen Kühlvorrichtung zur Verfügung gestellt werden.

Gelöst werden diese Aufgaben durch eine Kühlvorrichtung gemäss Patentanspruch 1, bei der den wärmeerzeugenden Einbauten über Zuführschächte individuell Kühlluft zugeführt wird und diese Zuführschächte vorzugsweise in einer Luftschachteinheit zusammengefasst sind die platzsparend im seitlichen Wandbereich des Serverschrankes angeordnet ist, einen Serverschrank mit einer erfindungsgemässen Kühlvorrichtung gemäss Anspruch 9 und ein Verfahren zum Betrieb einer solchen Kühlvorrichtung gemäss Anspruch 11.

Weitere vorteilhafte Ausführungsformen sind in den abhängigen Patentansprüchen beansprucht.

Im Folgenden werden anhand der beiliegenden Zeichnungen Ausführungsbeispiele der Erfindung beschrieben. Es zeigen:
- Figur 1: eine perspektivische Ansicht von schräg vorne auf einen Serverschrank mit einer Kühlvorrichtung gemäss einer ersten Ausführungsform der Erfindung, wobei die linke Seitenwand weggelassen ist;
- Figur 2: eine perspektivische Ansicht von schräg hinten auf den Serverschrank nach Figur 1;
- Figur 3: eine Ansicht auf die linke Seite des Serverschranks nach Figur 1; und
- Figur 4: eine sicht von unten auf den Serverschrank nach Figur 3.

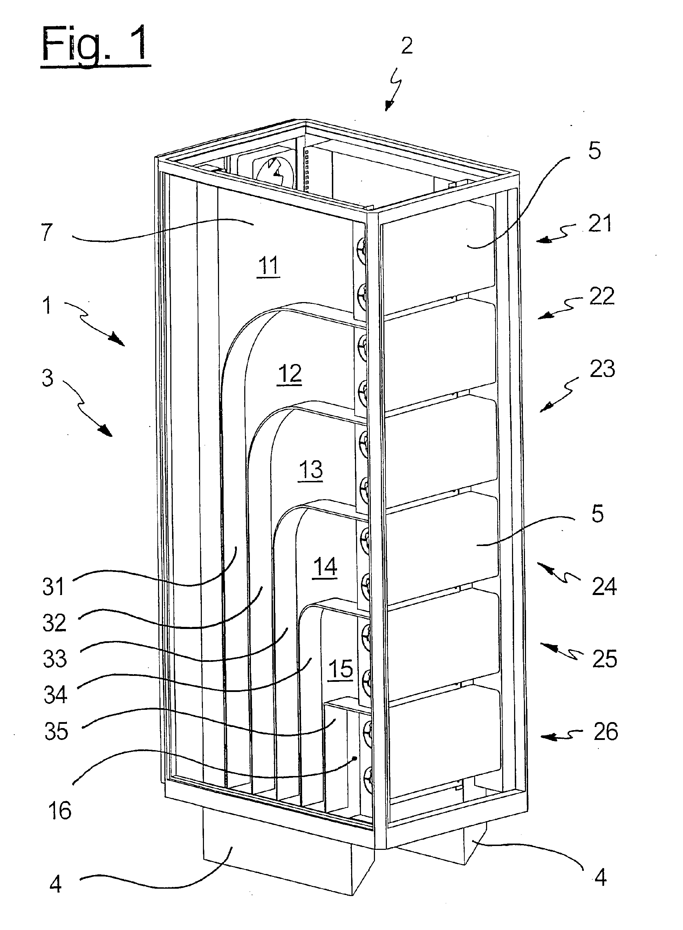

In der Figur 1 ist ein Serverschrank 2 mit einer Kühlvorrichtung 1 gemäss einer Ausführungsform der vorliegenden Erfindung dargestellt. Beim Serverschrank 2 ist eine rechte Seitenwand abgenommen, so dass die Sicht auf eine darunter liegende Luftschachteinheit 3 frei ist. Von dieser Luftschachteinheit 3 ist wiederum eine äussere Seitenwand 6 nicht gezeichnet, so dass deren innerer Aufbau mit sechs Zuführschächten 11-16, auch Windschächte genannt, sichtbar wird. Die Windschächte 11-16 weisen an ihrer Unterseite jeweils Lufteintrittsöffnungen 17 auf, die von unten über einen Windstutzen 4 mit kühler Luft versorgt werden. Die Serverschränke werden vorzugsweise in Systemräumen mit Hohlböden aufgestellt, in denen neben der Verkabelung auch die Kanäle einer zentralen Kühl- oder Klimatisierungseinrichtung verlaufen. Der Anschluss der Windstutzen 4 an die zentrale Kühlluftversorgung gestaltet sich dadurch denkbar einfach.

Die Luftschachteinheit 3 ist im dargestellten Ausführungsbeispiel durch fünf Staubleche 31-35

in sechs Windschächte 11-16 unterteilt und erlaubt dadurch die individuelle und gezielte Luftzufuhr zu sechs vertikal übereinander angeordneten wärmeerzeugenden Einbauten, zum Beispiel sechs Gehäusen 21-26 in denen jeweils ein Blade-Center untergebracht ist. Die Staubleche, die wie die Seitenwände der Luftschachteinheit gemäss einer vorteilhaften Ausführungsform der Erfindung aus 1,5 mm starkem Alublech gefertigt sind, sind vorzugsweise mit Gummilippendichtungen gegen die äussere Wand 6 abgedichtet und an der Innenwand 7 in bekannter Weise befestigt. Die Aussenwand 6 lässt sich zu Wartungs- oder Reinigungszwecken abnehmen.

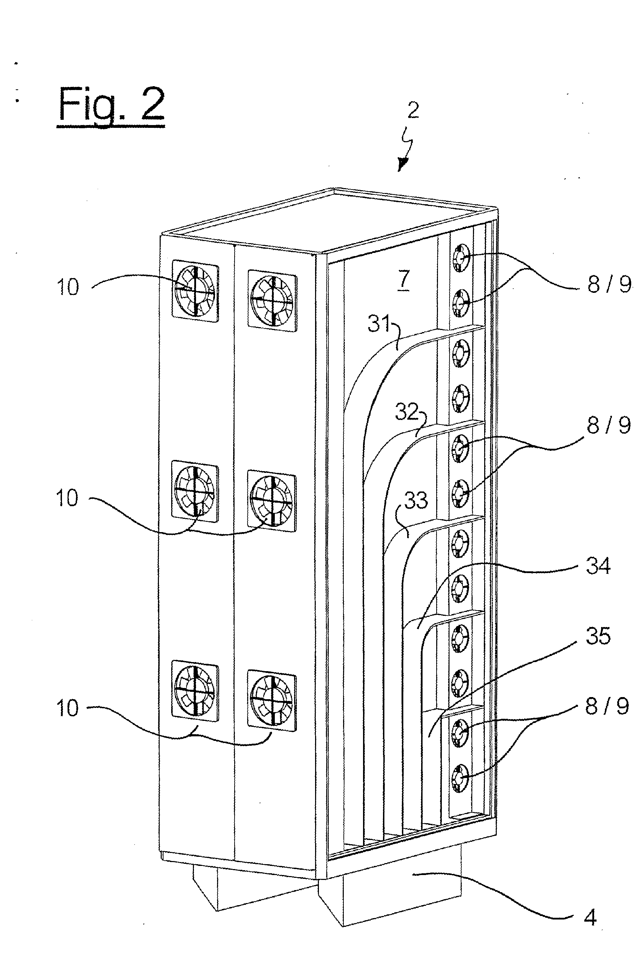

Jedes der Gehäuse ist frontseitig mit einer Haube 5, vorzugsweise aus Plexiglas, annähernd luftdicht verschliessbar. Die flache Windschachteinheit 3 ist durch eine Innenwand 7 gegen die Gehäuse 21-26, respektive gegen den Innenraum des Serverschrankes 2, hin abgeschlossen. Aus der Figur 2 wird klar, dass die einzelnen Windschächte 11-16 an ihren oberen Endbereichen über je zwei Luftaustrittsöffnungen 8 in der Innenwand 7 mit den zugehörigen Gehäusen 21-26 in Verbindung stehen. Individuell steuerbare Kühlluft-Ventilatoren 9, die in den Luftaustrittsöffnungen 8 angebracht sind, fördern die kühle Luft aus den Windschächten 11-16 in die jeweils zugeordneten Gehäuse 21-26. Die Luftaustrittsöffnungen 8 sind so platziert, dass die Gehäuse frontseitig mit Kühlluft versorgt werden. An der rechten Seite des Serverschrankes ist eine zweite Windschachteinheit angebracht, die im wesentlichen spiegelbildlich zur ersten aufgebaut ist. Die kühle Luft wird daher hinter den Hauben 5 von links und rechts seitlich in die Gehäuse geblasen und durch den Sog von rückwärtig angebrachten Ventilatoren 10 an den einzelnen Blades vorbei nach hinten gesaugt und in den Raum abgegeben. Die hinteren Ventilatoren können entweder jeweils einem einzelnen Gehäuse zugeordnet sein, oder wie in den Figuren dargestellt Gruppen von Gehäusen entlüften.

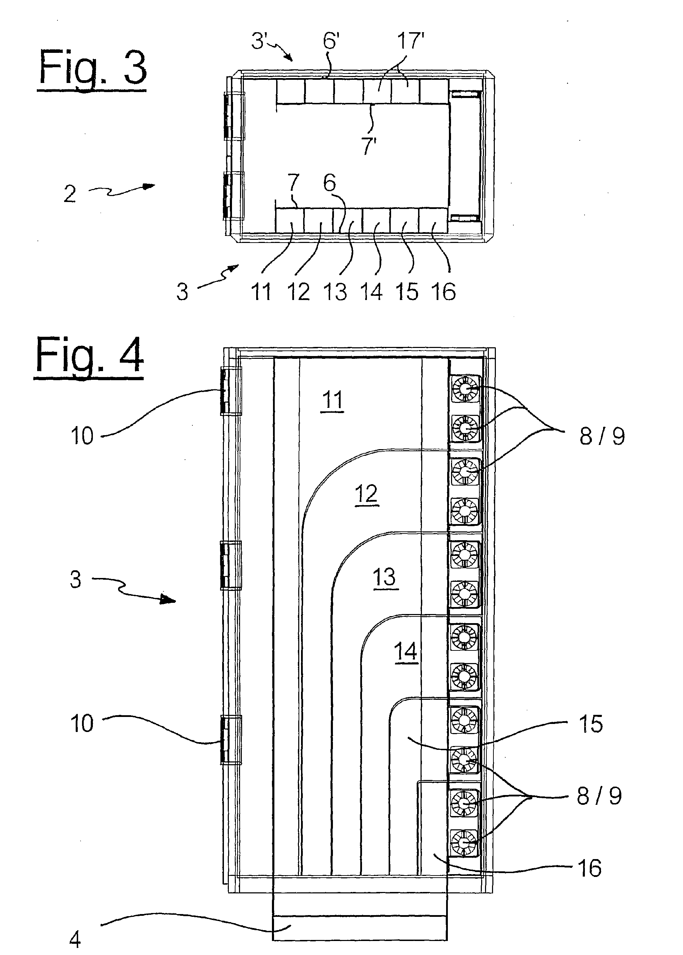

Im Ausführungsbeispiel gemäss der Figuren sind die einzelnen Windschächte 11-16 zu einer flachen quaderförmigen Einheit 3 zusammengefasst. Die Masse dieser Windschachteinheit 3 sind auf die Tiefe und die Höhe des seitlichen Schrankrahmens angepasst und füllen diesen im wesentlichen aus. Diese Formgebung erlaubt einen problemlosen Einbau in den Serverschrank, wobei die Breite der Windschachteinheit 3 so gewählt ist, dass im Innenraum des Schrankes eine genügende Breite für den Einbau der wärmeerzeugenden Einheiten, zum Beispiel der Blade-Center, vorhanden ist. Die Ansicht der Figur 4 verdeutlicht nochmals die seitliche Anordnung der beiden Windschachteinheiten 3, 3' im Serverschrank 2 und die regelmässige Dimensionierung der basalen Anteile der Windschächte 11-16 und 11'-16' in den Windschachteinheiten 3, 3'.

In der dargestellten Ausführungsform lassen sich mit einem Minimum an einfachen rechtwinkligen Bauteilen 6 Windkanäle auf äusserst effiziente und kostengünstige Weise herstellen.

Sollte es die individuelle Situation erforderlich machen, so können die Windstutzen auch direkt am Klimagerät angeschlossen werden. Auch eine direkte Abluftführung lasst sich mit dem erfindungsgemässen System verbinden, falls es gewünscht oder nötig ist, die erwärmte Abluft isoliert aus dem Raum mit dem Serverschrank abzuführen.

Bei den bisher bekannten luftgekühlten Systemen erfolgt die Luftzufuhr ungerichtet. Dies führt dazu, dass die unteren Server ausreichend aber die oberen Server oft nur mangelhaft gekühlt werden. Im Gegensatz dazu kann mit der Kühlvorrichtung gemäss der vorliegenden Erfindung jeder wärmeproduzierenden Einheit eine kontrollierte Kühlluftmenge zugeführt werden.

Die Temperatur an den Lufteintrittsöffnungen 17 und an den Gehäuseausgängen der einzelnen Einheiten lässt sich messen und entsprechend kann das Volumen an Kühlluft, das von den Kühlluft-Ventilatoren 8 über Windstutzen und Windschacht vom zentralen Kühlluftsystem im Boden angesaugt wird, geregelt werden.

Es kann auch die Temperatur in den einzelnen Gehäusen oder sogar an den Prozessoren der einzelnen Einheiten gemessen werden und der Kühlluftstrom entsprechend geregelt werden.

In einem Schrank nach 19-Zoll Technik mit 800 mm Breite und 1200 mm Tiefe in dem zum Beispiel 6 Gehäuse/Bladecenter angeordnet sind, beträgt der Durchfluss bei normalem Betrieb etwa 500 m³ Kühlluft pro Stunde und pro Bladecenter, was insgesamt also 3000m² pro Stunde für den Schrank bedeutet. Die Kühlluft wird mit vorzugsweise 18 °C zugeleitet und die Ablufttemperatur sollte unter 40°C, vorzugsweise bei 30°C, liegen. Vorzugsweise wird gemäss diesem Beispiel wird in zwei Stufen geregelt. Die vier Kühlluft-Ventilatoren 9 laufen im Normalbetrieb mit je 75% Leistung, bei welcher sie die 500m³ Kühlluft liefern können. Fällt einer der vier Ventilatoren aus, so werden die drei intakten Ventilatoren auf 100% Leistung hochgefahren und kompensieren praktisch übergangslos den Ausfall des defekten Ventilators. Schon diese einfache zwei Stufen Regelung stellt sicher, dass das Bladecenter immer mit dem benötigten Frischluftvolumen von 500m³ in der Stunde versorgt ist.

Die Leistung der Kühlluft- und der Abluft-Ventilatoren 9, 10 ist so aufeinander abgestimmt, dass ein kontinuierlicher Kühlluftstrom gewährleistet ist und möglichst keine Fremdluft angesaugt wird.

Ein weiterer wesentlicher Vorteil in der individuellen Kühlluftversorgung der einzelnen Bladecenter kommt bei einem Defekt in einem Blade oder einem Bladecenter zum Tragen. Die Anordnung der Bladecenter in Gehäuse, von denen jedes mit einer eigenen frontseitig angebrachten Haube verschliessbar ist, erlaubt es ein Gehäuse zu öffnen und Wartungs- oder Reparaturarbeiten durchzuführen, und gleichzeitig die restlichen Bladecenter ohne Unterbruch bei optimaler Kühlung weiter zu betreiben, da deren Kühlluftstrom intakt bleibt. Vorzugsweise sind die Kühlluft-Ventilatoren 9 eines jeden Gehäuses so gesteuert, dass sie abstellen, sobald die konvex gewölbte Haube 5 vom Gehäuse abgenommen wird.

Ist ein einzelnes Blade defekt, so können die übrigen Blades, die vorgängig optimal gekühlt waren, in der kurzen Zeitspanne des Austausches des defekten Teils problemlos weiterbetrieben werden. Die neue Kühltechnik erlaubt es also bei Reparaturen oder Wartungsarbeiten alle nicht direkt betroffenen Server weiterlaufen zu lassen, was zu einer erheblichen Reduktion der Ausfallzeiten führt.

Da die erfindungsgemässe Kühlvorrichtung mit Luft arbeitet, können kleinere Leckagen hingenommen werden. Das heisst, es ist nicht nötig dass das System völlig dicht ist, da ein kleinerer Verlust an Kühlluft von den Ventilatoren problemlos ausgeglichen werden kann. Sogar bei grossen Lecks kann die austretende Kühlluft keinerlei Schäden anrichten und die Temperaturüberwachung wird bei mangelnder Kühlleistung rechtzeitig Alarm geben. Die vorzugsweise Redundanz bei den Ventilationssystemen und den Windschachteinheiten, sowie Sensoren die die korrekte Funktion jedes Ventilators überwachen erhöhen zusätzlich die Sicherheit der Kühlvorrichtung.

### Liste der Bezugszahlen

- 1: Kühlvorrichtung
- 2: Serverschrank
- 3,3': Windschachteinheit
- 4: Windstutzen
- 5: Haube
- 6: äussere Seitenwand
- 7: innere Seitenwand
- 8: Luftaustrittsöffnung
- 9: Kühlluft-Ventilatoren
- 10: Abluft-Ventilatoren
- 11-16: Windschacht
- 17: Lufteintrittsöffnung
- 21-26: Gehäuse
- 31-35: Staubleche

## Patentansprüche

1. Kühlvorrichtung (1) zur Kühlung eines Serverschranks (2) mit einer Mehrzahl von wärmeerzeugenden Einbauten, die im Innenraum des Schrankes (2) vertikal übereinander angeordnet sind, **dadurch gekennzeichnet, dass** den wärmeerzeugenden Einbauten über Windschächte (11-16) individuell Kühlluft zuführbar ist.

2. Kühlvorrichtung (1) nach Anspruch 1, **dadurch gekennzeichnet, dass** die wärmeerzeugenden Einbauten jeweils in einem Gehäuse (21-26) untergebracht sind und diese in einem vorderen Bereich über Luftaustrittsöffnungen (8) mit mindestens einem Windschacht (11-16) in kommunizierender Verbindung stehen, so dass Kühlluft aus dem Windschacht vom vorderen Gehäusebereich an den Wärmeerzeugern vorbei in einen hinteren Gehäusebereich führbar ist.

3. Kühlvorrichtung (1) nach Anspruch 1, **dadurch gekennzeichnet, dass** in den Luftaustrittsöffnungen (8) Kühlluft-Ventilatoren (9) zum Einblasen der Kühlluft in die Gehäuse angebracht sind.

4. Kühlvorrichtung (1) nach Anspruch 1, **dadurch gekennzeichnet, dass** an einer Hinterseite der Gehäuse Abluftventilatoren (10) zum Absaugen der erwärmten Luft aus den Gehäusen (21-26) angeordnet sind oder solche Abluftventilatoren (10) mit den Hinterseite der Gehäuse (21-26) in kommunizierender Verbindung stehen.

5. Kühlvorrichtung (1) nach Anspruch 2, **dadurch gekennzeichnet, dass** jedes Gehäuse (21-26) frontseitig mit einer Haube (5) verschliessbar ist.

6. Kühlvorrichtung (1) nach Anspruch 1, **dadurch gekennzeichnet, dass** die Windschächte (11-16, 11'-16') vorzugsweise in einer Windschachteinheit (3, 3') zusammengefasst sind.

7. Kühlvorrichtung (1) nach Anspruch 6, **dadurch gekennzeichnet, dass** die Windschachteinheit (3, 3') durch äussere (8), innere (7), hintere, vordere und obere Seitenwände annähernd Luftdicht abgeschlossen ist und an einer Unterseite mit einem Windstutzen (4) in kommunizierender Verbindung steht.

8. Kühlvorrichtung (1) nach Anspruch 7, **dadurch gekennzeichnet, dass** im Inneren einer Windschachteinheit (3, 3') mit einer Anzahl von n Staublechen (31-35) eine Anzahl von n+1 Windschächten (11-16) gebildet sind.

9. Serverschrank (2) mit mindestens einer Kühlvorrichtung (1) nach einem der vorhergehenden Ansprüche 1 bis 8.

10. Serverschrank (2) nach Anspruch 9, **dadurch gekennzeichnet, dass** mindestens eine Windschachteinheit (3, 3') seitlich in den Rahmen des Serverschrankes eingepasst ist.

11. Verfahren zum Betrieb einer Kühlvorrichtung (1) zur Kühlung eines Serverschranks (2) mit einer Mehrzahl von wärmeerzeugenden Einbauten, die im Innenraum des Schrankes (2) übereinander angeordnet sind, **dadurch gekennzeichnet, dass** den wärmeerzeugenden Einbauten über individuell zugeordnete Windschächte (11-16) gezielt Kühlluft von einer externen Kühlluftquelle zugeführt wird, wobei das benötigte Kühlluftvolumen ermittelt und ein individueller Kühlluftstrom über mindestens einen Ventilator je Winschacht erzeugt wird.

12. Verfahren nach Anspruch 11, **dadurch gekennzeichnet, dass** die Kühlluft mittels Kühlluft-Ventilatoren (9) die im Kühlluftstrom vor den wärmeerzeugenden Einbauten angeordnet sind und mittels Abluft-Ventilatoren (10), die im Kühlluftstrom nach den wärmeerzeugenden Einbauten angeordnet sind, an diesen Vorbeigeleitet wird, wobei die Ventilatoren in der Förderleistung aufeinander abgestimmt betrieben werden.
